Europäisches Patentamt

European Patent Office

Office européen des brevets

(11) Publication number: **0 133 201**
**B1**

(12) **EUROPEAN PATENT SPECIFICATION**

(45) Date of publication of patent specification: **01.03.89**

(51) Int. Cl.⁴: **C 04 B 41/88**

(21) Application number: **84106252.4**

(22) Date of filing: **01.06.84**

(54) Metallization of ceramics.

(30) Priority: **09.06.83 US 502748**
**21.05.84 US 611193**

(43) Date of publication of application:
**20.02.85 Bulletin 85/08**

(45) Publication of the grant of the patent:
**01.03.89 Bulletin 89/09**

(84) Designated Contracting States:
**AT CH DE FR GB IT LI NL SE**

(56) References cited:
**FR-A-2 348 279**
**US-A-4 046 620**

(73) Proprietor: **KOLLMORGEN TECHNOLOGIES**
**CORPORATION**
**66 Gatehouse Road**
**Stamford Connecticut 06902 (US)**

(72) Inventor: **De Luca, Michael Albert**
**1534 Clas Avenue**
**Holbrook, NY 11741 (US)**
Inventor: **McCormack, John F.**
**116 Millburn Lane**
**Roslyn Heights, NY 11577 (US)**

(74) Representative: **Königseder, geb. Egerer,**
**Claudia**
**Zugspitzstrasse 65**
**D-8104 Grainau (DE)**

Courier Press, Leamington Spa, England.

**Description**

This invention relates to metallized ceramic articles and to a metallized conductor pattern directly and adherently bonded onto a surface of a ceramic substrate, and an improved process for producing same. More particularly, this invention relates to a metal deposit, e.g., a printed circuit pattern directly and adherently bonded onto a surface of a ceramic substrate, and an improved process for producing same employing material in solution to promote adsorption of a species suitable for rendering said surface receptive for metal deposition.

Metallized conductor patterns on ceramic substrates have been widely used in the electronic industry. For many years, ceramics have been metallized by high cost processes such as fused metal-glass pastes and thin film vacuum deposition techniques. Attempts to reproducibly make circuit patterns by direct electroless deposition have not been successful due to poor adhesion of the metal films to the substrate and non-reproducible and non-uniform surface coverage. Printed circuits on ceramics, including alumina, were described as early as 1947 in, e.g., "Printed Circuit Techniques" National Bureau of Standards, Circular 468 (1947) and National Bureau of Standards, Misc. Pub. 192 (1948). One type, known as a thin film circuit, consists of a thin film of metal deposited on a ceramic substrate by one of the vacuum plating techniques. In these techniques, a chromium or molybdenum film, having a thickness of about 0,02 μm, acts as a bonding agent for copper or gold layers. Photolithography is used to produce high resolution patterns made by etching away the thin metal film. Such conductive patterns may be electroplated up to, typically, 7 μm thick. Due to their high cost, thin film circuits have been limited to specialized applications such as high frequency applications and military applications where a high pattern resolution is vital.

Another type of printed circuit, known as thick film circuit, comprises a conductor pattern consisting of a metal and glass film fired on a ceramic substrate. Typically, the film has a thickness of about 15 μm. Thick film circuits have been widely used. Thick film conductors are produced by screen printing in a circuit pattern with a paste containing a conductive metal powder and a glass frit in an organic carrier. After printing, the ceramic parts are fired in a furnace to burn off the carrier and sinter the conductive metal particles and fuse the glass. These conductors are firmly bonded to the ceramic by the glass and thus components may be attached to the conductors by soldering, wire bonding and the like. Conductors in thick film circuits have only 30 to 60 percent of the conductivity of the pure metal. There is, however, a need for the high conductivity of pure metal to provide interconnections for high speed logic circuits.

The minimum conductor width and the minimum space between conductors which can be obtained by screen printing and firing under special high quality procedures is 125 and 200 μm, respectively. However, under normal production conditions, these minima are 200 and 250 μm, respectively. For ceramic circuits requiring higher interconnection density, i.e., higher connectivity, multilayer techniques are, therefore, used.

In the thick film multilayer process, a first layer of metal powder and glass frit is printed on a ceramic substrate and fired, typically at 850°C. Subsequently, an insulating dielectric layer is screened over the conductor pattern, leaving exposed only the points at which contact is to be made to the next layer of metallization. This dielectric pattern, also, is fired at, e.g., 850°C and this procedure repeated to form a second dielectric layer and free of pinholes. The next conductor pattern layer is printed and fired making contact to the conductors of the lower conductor layer, as necessary, through the openings left in the dielectric layers.

Typical thick film multilayer ceramic packages contain two to six layers of metallization, and eight layers of circuit patterns are not uncommon. For two layers the substrate will be printed four times and fired at 850°C for four times, for three layers seven times, and for four layers ten times.

By the process of the present invention, the connectivity of a three or four layer thick film multilayer ceramic circuit can be achieved by a two-sided, plated through hole, conductor pattern.

Attempts have been made in the past to directly bond pure metal conductors to ceramic substrates including alumina in order to achieve higher conductivity for ceramic based circuit patterns. (US—PS 3 766 634 and US—PS 3 744 120). Solid State Technology 18/5, 42 (1975) and US—PS 3 994 430 disclose a method for bonding copper sheets to alumina by heating the copper in air to form an oxide film on its surface. The thus prepared copper sheet is bonded to alumina at a temperature between 1 065°C and 1 075°C in a nitrogen furnace. In order to obtain well adhered copper foil without blisters, (1) the copper foil must be carefully oxidized to a black surface, (2) the copper oxide thickness must be carefully controlled, (3) the amount of oxygen in the copper foil must be controlled, (4) the oxygen content of the nitrogen furnace must be maintained at a controlled level to maintain a very moderately oxidizing atmosphere, and (5) the temperature must be controlled within one percent. In spite of the difficult operating conditions, the process of US—PS 3 994 430 is being introduced into commercial application because of the need for the metallized product.

Although the above described systems are commercially used, the need for direct, simple metallization of ceramics for producing pure metal conductors, such as copper, has prompted a continuous series of patents and proposed processes, as, e.g., DE—PS 20 04 113, 24 53 192, 24 53 277 and 25 33 524. In US—PS 3 296 012 is disclosed a method of producing a microporous surface for electrolessly plating alumina. Attempts to simply apply electroless metallization directly to ceramic substrates have continually been tried and never been commercially successful. Even such toxic and corrosive materials as hydrogen fluoride were tried to allow the direct bonding of electroless metal to ceramics without extreme firing temperatures. Compare Ameen et al, J. Electrochem. Soc., 120, 1518 (1973). However, the hydrofluoric etch concept gave poor strength of the bond due to excessive attack on the surface of the ceramic.

Another attempt, disclosed in US—PS 3 690 921, involved the use of molten sodium hydroxide to etch a ceramic surface. In this process, subsequently, sodium hydroxide is rinsed from the ceramic surface with water, the ceramic surface neutralized with dilute sulfuric acid and rinsed again before sensitizing with a stannous chloride solution, rinsing and seeding with a palladium chloride solution, to catalyze said surface for electroless metal plating.

Although a metal film deposit with good bond strength is achieved by this process, nonetheless, it did not reach acceptance for commercial production. The reason is poor surface coverage by the electrolessly deposited metal. Although the metal deposit usually covered 90% of the surface area or even more, this was unacceptable; any imperfection in the formed metal film may cause defective circuit conductors and a failure if such imperfection occurs in a fine line conductor pattern to a complete operating failure.

With prolonged immersion in both the stannous chloride sensitizer solution and the palladium chloride seeder solution as well as incomplete rinsing steps, it sometimes may be possible to achieve substantially complete surface coverage with metal. Such approach is, however, not practical for production purposes. Incomplete rinsing after the stannous chloride solution treatment leads to loosely adhering precipitate particles forming in the palladium chloride seeder and in the electroless plating solutions and to the rapid decomposition of these solutions.

US—PS 4 428 986 discloses a method for direct autocatalytic plating of a metal film on beryllia. The method comprises roughening the surface of the beryllia by immersing in a 50 percent sodium hydroxide solution at 250°C for 7 to 20 minutes, rinsing with water, etching the beryllia substrate with fluoroboric acid for 5 minutes, rinsing with water, immersing it in a solution of 5 g/l stannous chloride and 3N hydrochloric acid, rinsing with water, treating the beryllia surface with a 0,1 g/l palladium chloride solution, rinsing with water, and then electrolessly plating nickel on the beryllia. In the etching step, silica and magnesium are removed from the grain boundaries of the beryllia thereby weakening the beryllia surface. As a result, the method of US—PS 4 428 986 was able to achieve only 1,7 MPascal bond strength before the beryllia substrate broke. This bond strength is too low for practical use being approximately one third of the bond strength normal in thick film type circuits.

The prior art processes described are unreliable as they result in incomplete surface coverage with or unacceptably low bond strength of the formed metal deposits, or both, and are, therefore, completely unsatisfactory for production purposes.

Other suggested methods of forming printed circuit patterns on ceramic substrates are disclosed in the following US—PS: 3 772 056, 3 772 078, 3 907 621, 3 925 578, 3 930 963, 3 959 547, 3 993 802 and 3 994 727 further indicating the strong and since considerable time existing interest in such circuits.

None of the prior art teachings discloses, however, how to solve the problem of poor surface coverage and inadequate bond strength between metal deposit and ceramic surface.

Ceramic packages have been widely used, e.g., to protect microelectronic circuits such as integrated and hybrid circuits from contamination by the outside environment. A hermetic seal is required between the ceramic base of the package and its cover to exclude the outside environment. Heretofore, hermetic seals have been provided by the following methods for ceramic dual-in-line packages utilized in the microelectronics industry.

In one method, a refractory metal paste, usually comprising a molybdenum-manganese alloy, is applied to a ceramic base. The paste and the ceramic base are fired at 1 500—1 800°C in an inert or a reducing atmosphere in order to fuse the molybdenum-manganese alloy to the ceramic surface. The refractory metal alloy is then plated with gold or with nickel and gold. A microelectronic circuit is inserted within a cavity of the ceramic base through an opening in said base. The microelectronic circuit is connected to feed throughs provided in the base. The opening in the ceramic base is hermetically sealed by covering it with a cover which is soldered in place around the periphery of the opening. Gold plated Kovar lids or ceramic lids provided with gold plated molybdenum-manganese surfaces are used as covers. Soldering takes place in a nitrogen atmosphere using gold-tin solders or tin-silver-antimony solders.

This process, while capable of producing good hermetic seals, is characterized by very high cost because of the difficulties related to the very high firing temperatures. Epoxy adhesives also have been used to provide seals between a ceramic package and a lid. This method is unsatisfactory because organic vapors from the epoxy sealant may contaminate the microelectronic circuit.

Still another method of forming hermetic seals for a ceramic package is to use a low melting glass which is applied as a glass paste with a carrier solvent and then fused in a furnace. This method is unsatisfactory because it may seal solvents from the glass paste into the package along with some of the glass itself. Reliability of the circuit can be destroyed by contamination due to the solvent trapped in the glass interlayer.

It is the object of the present invention to avoid the above described problems of the prior art and to provide a method of applying a metal film or layer to a ceramic substrate and obtaining substantially complete surface coverage and a bond strength between metal layer and ceramic of at least 3 MPa, and preferably not less than 5 MPa. A further object of the invention is to provide an electrolessly deposited, direct bonded conductor pattern having excellent adhesion to a ceramic substrate and a process for producing the metal coated ceramic substrate.

Another object of the invention is to produce a metal plated ceramic substrate which may be used for fine line printed circuit pattern applications with highly pure metal conductors.

Another object of the invention is to provide a ceramic substrate with conductors suitable for interconnection in high speed logic circuits and a process for producing the same. A further object of the invention is to provide a ceramic substrate with a conductor pattern on both sides and at least one through hole connection having a metallized wall and a conductor density comparable to at least a three or four layer thick film multilayer ceramic.

It is also an object of the invention to provide a method of joining metallized ceramics by soldering, brazing or welding or other known methods and to provide a hermetic seal.

Additional objects and advantages of the invention will be set forth in the description.

The present invention is directed to a method of producing metal films or layers on ceramic substrates including alumina which provide substantially complete surface coverage and excellent bond strength between metal deposit and ceramic, i.e. at least 3 MPa, preferably in excess of 5 MPa, as measured by the "dot pull test" described herein below. It also includes ceramic substrates having printed circuit patterns formed from such films or metal layers. The process of this invention may be used to treat ceramic substrates for electroless or electrolytic metal deposition.

Metal deposits on the ceramic substrate or article are obtained having a thickness of at least 0,2 μm, preferably at least 2 μm, and conductor features typically with a width of 25 μm, preferably 50 μm.

In another embodiment, the process of this invention also includes joining the metallized ceramic substrate to a metal or to another metallized ceramic substrate by soldering, brazing or welding.

In accordance with the present invention there is claimed a method for partially or completely coating a ceramic article or substrate with a metal layer directly and securely bonded to the said substrate comprising at least the following steps:

(a) treating the substrate surface with a melt comprising one or more alkali metal compound(s); and

(b) exposing said surface to a solution comprising a surface active agent selected from ethoxylated nonionic compounds and nitrogen containing compounds, selected from quaternary compounds, amine oxides, alkanol amines, amides, betaines, amino acids and guanadine and derivates, and mixtures of the foregoing, in an amount sufficient to promote uniform and secure adsorption of species rendering said surface receptive for metal deposition, said solution having a pH of 2 and being used in a pre-treatment step prior to, or constituting part of the solution(s) employed in the process sequence for rendering said surface receptive for metal deposition; and

(c) exposing the thus treated surface or selected parts thereof to a metal plating bath solution for depositing the desired metal on said surface thus forming a substantially completely uniform, defect-free deposit free of bare spots and securely bonded to the ceramic substrate or article.

In accordance with the present invention, any platable metal may be deposited on the surface of a ceramic substrate or article. Typically, copper, nickel, silver or cobalt metal films may be electrolessly deposited.

Many alkali metal compounds have been found to be suitable for adhesion promotion, e.g., etching of ceramics. Preferred alkali metal compounds include sodium hydroxide, potassium hydroxide, sodium carbonate and potassium nitrate, and potassium hydrogen sulfate.

It is preferred to use compounds with lower melting points. Alternatively, the melting points of the alkali metal compound(s) may be depressed by dissolving up to about 50% by weight, preferably up to 20% by weight, of low melting materials or even liquids in the alkali metal compound(s). Examples of such melting point depressants are believed to include stannous chloride, nitric acid, water, sodium and potassium formates, potassium acetate, Rochelle salts, borax, and the hydrates of lithium bromide, iodide and phosphate, and potassium pyrophosphate.

Sometimes, it may be preferable to avoid hydroxides for safety reasons and for ease of neutralization. Typical alkali metal compounds suitable for use in the invention and their melting points as reported in Lange's Handbook of Chemistry, 11th Edition (1972) are as follows:

<table>
<tr><td colspan="5" align="center">Melting Point °C</td></tr>
<tr><th>Alkali metal</th><th>Hydroxide</th><th>Nitrate</th><th>Carbonate</th><th>Hydrogen sulfate</th></tr>
<tr><td>Lithium</td><td>445</td><td>261</td><td>618</td><td>171</td></tr>
<tr><td>Sodium</td><td>328</td><td>308</td><td>851</td><td>315</td></tr>
<tr><td>Potassium</td><td>360</td><td>334</td><td>891</td><td>214</td></tr>
<tr><td>Rubidium</td><td>300</td><td>310</td><td>837</td><td>—</td></tr>
<tr><td>Cesium</td><td>272</td><td>414</td><td>—</td><td>—</td></tr>
</table>

4

Eutectic mixtures such as a mixture of potassium hydroxide and sodium hydroxide or a mixture of sodium carbonate and potassium nitrate also may be used to etch the substrate. The former type of mixture preferably has a percent by weight ratio of 59:41 of KOH to NaOH with a melting point of 170°C.

Typical of the ceramic substrates etched by the molten compounds employed herein are aluminas, silicates, beryllias, titanates, forsterite, mullite, steatite, porcelains and mixtures of the foregoing.

Typical of the metal deposition solutions used are electroless plating solutions for nickel, cobalt, gold and copper. Electrolytic deposition solutions also may be used in the practice of this invention.

Applicants have discovered that adsorption of the species rendering the thus prepared ceramic surface receptive to metal deposition, and eventually surface coverage of the metal deposit formed on it, is greatly enhanced by treatment of the etched surface with a compound that is adsorbed on such ceramic surface and promotes substantially uniform adsorption of said species, e.g., the sensitizing seeding or catalyzing species over the whole surface, and surprisingly, provides complete defect-free metal coverage. Among the compounds that can be adsorbed and promote adsorption of said species are certain surface active agents selected from the group listed hereinbefore.

Among the suitable quaternary compounds are complex quaternary surfactants (Varex 68™); quaternary ammonium compounds such as quaternary ammonium chlorides (Emulsifier Four™ and Emulsifier Five™ and Katapone VV-32B™); polyethoxylated oleyl and stearic quaternary ammonium chlorides (Ethoquad O/12™ and Ethoquad 1B/12™); polypropoxylated quaternary ammonium chlorides (Emcol CC-9™, Emcol CC-36™, Emcol CC-42™ Emcol CC-55™ and Emcol CC-57™); and quaternary pyridinium compounds such as cetyl pyridinium bromide.

Among the suitable amine oxides is myristylcetyldimethylamine oxide (Ammonx MCD™).

Among suitable alkanolamines are ethanolamine and block copolymers of ethylene oxide and propylene reacted with ethylenediamine (Tetronic 1504™).

Among the suitable amides are alkylolamides such as lauric ethoxylated amide (Unamide L-5™) and the coco ethoxylated amides (Unamide C-5™ and Ammidox C-5™).

A suitable amino acid and guanadine derivative is creatine. Suitable betaines include tallow betaine surfactants (Mirataine™).

Combinations of these surface active agents are also useful for promoting the adsorption of either stannous ion sensitizers or unitary noble metal catalyst solutions comprising both palladium and tin, other catalyst combinations of noble metals and elements from Group IV of the Periodic Table of Elements or other species rendering surfaces receptive for metal deposition.

Among the surface active agents promoting adsorption are the non-ionic surfactants such as the alkylphenoxypolyglycidols, e.g., nonylphenoxypolyglycidol (Olin 6G™). While not wishing to be bound by theory, it is believed that adsorption of the strongly negatively charged sensitizing or catalyzing species, such as stannous chloride or the unitary palladium chloride-tin chloride catalysts, is enhanced by cationic surface active agents and such agents containing positive nitrogen dipoles. Non-noble metal catalysts are frequently neutral or only mildly negative or mildly positive species, so that adsorption is enhanced by non-ionic surfactants.

The surface active agent may be used in an aqueous solution at concentrations above about 10 mg/l, preferably above about 100 mg/l, and more preferably above about 1 g/l, and below about 10 g/l, preferably below about 6 g/l and sufficient to completely cover the ceramic surface with an adsorbed layer. If the concentration is too low or the contact time too short, the ceramic surface will not be completely covered with said absorbed layer. This condition is characterized by "skip plating" in subsequent metal deposition. If the concentration of the solution comprising the surface active agent is too high, the adsorbed layer will be too thick and poorly adherent, leading to blistering of the subsequently formed metal deposit.

The nitrogen containing, surface active agents can be used as a pretreatment for the ceramic substrate after exposure to the melt treatment, rinsing, neutralizing and rinsing again, and before treating with, e.g., stannous chloride sensitizer solution. It has been found that with such pretreatment, the sensitizer is quickly adsorbed on the etched ceramic substrate so that the immersion in the sensitizing solution is not unduly prolonged. In addition the adsorbed tin species is securely adsorbed so that it is not inadvertently removed in a conventional rinsing step.

Numerous processes are employed in the manufacture of printed circuit boards. As will be understood by those skilled in the art, these printed circuit manufacturing processes may be used in conjunction with the method of this invention and with the steps of rendering the ceramic surface receptive to metallization in order to produce metallized ceramic printed circuit boards.

Other modes of operating this invention are inter alia, disclosed in the examples.

## Example I

Two white 96% alumina substrates, 30 × 30 mm and 0,4 mm thick, were immersed in an alkaline cleaning solution (Altrex™) for 10 minutes at a temperature of 60°C, water rinsed for 1 minute at 25°C, dipped in a solution of sodium hydroxide (760 g/l), removed and allowed to drain. The resulting wet ceramic substrates were placed on edge in a support fixture and dried for 10 minutes at 175°C. Then, the substrates were heated in a furnace for 15 minutes at 450°C to melt the sodium hydroxide. After cooling, the ceramic substrates were rinsed in water, in 20% sulfuric acid at 25°C for 2 minutes and, subsequently, in deionized water for 2 minutes at 25°C.

One of the thus prepared alumina substrates was immersed for 5 minutes in an aqueous solution containing an amphoteric surfactant (tallow betaine surfactant), 1,4 g/l, an nonionic surfactant (nonylphenoxypolyethoxyethanol), 1 g/l, and ethanolamine, 1 ml/l, the solution adjusted to pH 2, and then rinsed in water.

Both substrates were coated with copper by the following procedure:

1. Immerse for 10 minutes at room temperature in a sensitizer solution consisting of 59 g of stannous chloride dissolved in 1 liter of 0,12 molar hydrochloric acid solution;

2. Rinse in deionized water at room temperature;

3. Immerse for 2 minutes at room temperature in an activator solution of 0,1 g palladium chloride dissolved in 1 liter of 0,012 molar hydrochloric acid; and

4. Plate for 30 minutes at room temperature in an electroless copper plating bath solution consisting of

| | |
|---|---|
| Copper sulfate | 10 g/l |
| Ethylenediamine tetra-2-hydroxypropanol | 17 g/l |
| Formaldehyde | 6 g/l |
| Block copolymer of ethylene oxide and propylene oxide | 10 mg/l |
| Sodium cyanide | 10 mg/l |
| Sodium hydroxide to | pH 13 |

The ceramic substrate which was immersed in the surfactant solution was found to be coated with a uniform, adherent, electrolessly deposited copper layer, while the ceramic substrate not treated with the surfactant solution exhibited skip plating, i.e., portions of the surface were not covered with copper.

Example II

The procedure of Example I was repeated except that three different solutions were used. All three solutions contained 1,4 g/l of the tallow betaine surfactant with the pH adjusted for solution No. 1 to 2, solution No. 2 to 4,6 and solution No. 3 to 9,9.

After the electroless copper deposition step, the ceramic substrates conditioned at a pH of 2 and at a pH of 4,6 both had uniform adherent copper deposits free from skip plating, blisters or other defects. The ceramic substrate treated with the solution having a pH of 9,9 exhibited skip plating and a defective copper layer.

Example III

The procedure of Example II was repeated except that 1 g/l solutions of monoethanolamine at a pH of 2 and at a pH of 10,9, respectively, were used as surfactant solutions. After the electroless deposition of copper, the ceramic substrate conditioned at a pH of 2 had a uniform, adherent copper surface, while the substrate treated with the solution having a pH of 10,9, again, exhibited skip plating.

Example IV

A white 96% alumina substrate, 30 x 30 mm and 0,4 mm thick was processed by the procedure of Example I up to the final rinsing step subsequent to the melt treatment. It was then coated with copper by the following procedure (reference is made to co-pending patent application No.

1. Immerse for 5 minutes in an aqueous solution containing an amphoteric surfactant (tallow betaine surfactant), a non-ionic surfactant (nonylphenoxy polyethoxyethanol) and ethanolamine and pH adjusted to 2.

2. Rinse in water.

3. Immerse for 2 minutes in a room temperature aqueous halide predip solution of 3,8 moles sodium chloride, 0,1 moles hydrochloric acid and 0,085 moles stannous chloride per liter.

4. Immerse for 5 minutes in a catalyst solution having the composition shown below:

# EP 0 133 201 B1

### Catalyst Composition

| | (g/l) Halide: |
|---|---|
| Palladium | 0,15 |
| Stannous chloride | 23,00 |
| Sodium chloride | 226,00 |
| Hydrogen chloride | 4,60 |
| Resorcinol | 1,20 |

5. Rinse in water.

6. Electrolessly deposit copper for 30 minutes at room temperature in an electroless copper plating solution of the following composition:

| | | |
|---|---|---|
| Copper(II)chloride | 6 | g/l |
| Ethylenediamine tetra-2-propanol | 17 | g/l |
| Formaldehyde | 8 | g/l |
| Block copolymer of ethylene oxide and propylene oxide | 1 | mg/l |
| Sodium hydroxide | 15 | g/l |
| Sodium cyanide | 10 | mg/l |
| Potassium sulfide | 0,8 | mg/l |
| Sodium mercaptobenzothiazole | 0,1 | mg/l |

A uniform coating of copper was obtained free of voids and skip plating. The copper clad ceramic was coated with a polyvinylcinnamate polymer (KPR™), exposed through a printing master and developed with KPR™ developer solution to produce the negative resist image of a chip carrier. The exposed copper surface, corresponding the desired chip carrier pattern, was electroplated in a copper electroplating solution (Copper Gleam PC™) to a copper thickness of 0,01 mm. Subsequently, the resist was removed with solvents, and the thus exposed electroless copper deposit, outside the chip carrier image pattern, removed by immersion in a solution of sodium persulfate thus producing a finished chip carrier with 132 conductors on 0,14 mm pitch fanning out to 0,36 mm pitch.

### Example V

The procedure of Example IV was repeated on both 90% and 96% alumina substrates, 75 × 75 mm and 0,4 mm thick. Instead of a chip carrier conductor pattern, eight copies of a copper conductor pattern for a hybrid circuit A/D (analog to digital) converter were produced on each substrate. The hybrid circuit conductor patterns have 125 μm wide pure copper conductors, input and output connections and all the interconnections for six integrated circuits and associated chip capacitors and resistors.

After the circuit patterns were completed by removing the electroless copper deposit in the background, the individual hybrid circuits were cut out of the 75 × 75 mm wafer using a laser beam. Alternately, the individual circuit patterns are laser cut after the integrated circuits, chip resistors and capacitors are emplaced.

### Example VI

The procedure of Example V was repeated except that the hybrid circuit conductor patterns were electroplated with nickel and gold over the electroplated copper. This produced a circuit with a clean, smooth, pure gold surface found to be substantially superior for wire bonding compared to screened gold paste thick film circuits.

7

### Example VII

A 64 pin chip carrier was produced on alumina substrate.

The substrate was provided with laser drilled holes of 0,4 mm in diameter and the chip carrier was produced by the method of Example IV except that the conductor pattern was produced on both sides of the substrate with plated through hole wall connections formed simultaneously.

### Example VIII

Four black ceramic substrates, 90% alumina, were treated by the procedure of Example I up to the final rinsing step after the melt step. Three of the substrates were immersed in a 6 g/l solution of nonylphenoxypolyglycidol (Olin 6G™). The immersion times were varied from 5 minutes to 1 hour. Subsequently, the substrates were immersed for 30 minutes at 65°C in the following sensitizer solution:

| | |
|---|---|
| Sorbitol | 85 g/l |
| 2,6-anthraquinone di-sulfonic acid disodium salt | 11 g/l |
| Cupric acetate | 5,6 g/l |
| Cupric bromide | 0,35 g/l |
| Nonylphenoxypoly-glycidol | 1,5 g/l |
| Fluoroborc acid to pH | 4 |
| Ethanol | 300 ml/l |

After removal excess solution was wiped from the substrates with a sponge, and the substrates were dried and exposed to a medium pressure mercury vapor lamp for 90 seconds to produce a layer of catalytic sites on the substrate. The said sites were fixed in a solution of 100 ml/l of 37% formaldehyde and 40 g/l of tetrasodium EDTA adjusted to pH 12,5.

After fixing, the substrates were rinsed and plated with an electroless copper deposit 10 μm thick in the following electroless plating solution:

| | | |
|---|---|---|
| Copper sulfate | 0,4 | mole/l |
| Ethylenedinitrilotetra-2-propanol | 0,12 | mole/l |
| Formaldehyde | 0,05 | mole/l |
| Alkylphenoxyglycidol-phosphate ester | 0,2 | millimole/l |
| Sodium cyanide | 0,5 | millimole/l |
| Potassium selanocyanate | 0,7 | millimole/l |
| pH | | 12,8 |
| Temperature | | 56 °C |

After plating, the substrates were rinsed, dried and baked at 160°C for 1 hour.

The substrate which had not been immersed in the 6 g/l solution of nonylphenoxypolyglycidol exhibited skip plating, i.e., it was not completely covered with a copper layer. The ceramic substrates which had been immersed in the 6 g/l solution of nonylphenoxypolyglycidol were completely covered with a uniform copper layer.

The adhesion of the deposited copper to the ceramic substrate was tested by the "dot pull test". For this test, the substrates were imaged and etched by conventional photolithographic techniques, producing copper dots 2,5 mm in diameter. Wires were attached to the copper dots with solder and the force required to separate the copper dots from the ceramic substrate was measured. The following results were obtained:

| Surfactant Immersion Time (Min.) | Bond Strength (MPa) |
|---|---|
| 0 | skip plating incomplete coverage |
| 5 | 10,0 |
| 15 | 12,0 |
| 60 | 8,2 |

### Example IX

The procedure of Example VIII was repeated except that the substrates were immersed for only 5 minutes in the 6 g/l solution and in the sensitizer solution. The measured bond strength was 7,5 MPa.

### Example X

The procedure of Example VIII was repeated using a 30 min. immersion in a 3 g/l solution of the nonylphenoxypolyglycidol surfactant prior to the 30 minutes immersion in the sensitizer solution. Equivalent adhesion and surface coverage without skip plating were obtained.

### Example XI

The procedure of Example VIII was repeated using the 30 minutes immersion in the surfactant solution. Upon exposure to the mercury vapor lamp, a photographic negative of a hybrid circuit pattern was positioned over the black alumina substrate and a real image of the hybrid circuit pattern produced on the substrate. In the electroless copper deposition step, this real image was converted into an adherent conductor pattern on the alumina substrate.

### Example XII

The procedure of Example XI was repeated substituting a 24 pin dual-in-line hybrid circuit package for the flat alumina substrate. The dual-in-line package had a cavity for reception of a hybrid circuit. Instead of inserting a hybrid circuit package into said cavity, a hybrid circuit pattern was produced directly on the floor of the cavity by the procedure of Example XI. The photographic negative was held in place against the floor of the cavity during the exposure and copper electrolessly deposited to form the conductor pattern.

The copper conductor pattern was overplated with electrolessly deposited nickel and gold by standard electroless plating techniques. The hybrid circuit was completed by mounting integrated circuit chips, chip resistors and capacitors on the conductor pattern and making wire-bond connections to the 24 pins of the package.

The formation of the conductor pattern and mounting of the integrated circuits directly on the floor of the package greatly improved heat transfer compared to the conventional method of forming the hybrid circuit on a separate piece of alumina and then bonding the alumina to the floor of the package.

## Claims

1. A method for partially or completely coating a ceramic article or substrate with a metal layer directly and securely bonded to the said article or substrate, comprising the following steps:

(a) treating the substrate surface with a melt comprising one or more alkali metal compound(s); and

(b) exposing said surface to a solution comprising a surface active agent selected from ethoxylated nonionic compounds and nitrogen containing compounds, selected from quaternary compounds, amine oxides, alkanol amines, amides, betaines, amino acids and guanadine and derivates, and mixtures of the foregoing, in an amount sufficient to promote uniform and secure adsorption of species rendering said surface receptive for metal deposition, said solution having a pH of 2 and being used in a pre-treatment step prior to, or constituting part of the solution(s) employed in the process sequence for rendering said surface receptive for metal deposition; and

(c) exposing the thus treated surface or selected parts thereof to a metal plating bath solution for depositing the desired metal on said surface thus forming a substantially completely uniform, defect-free deposit free of bare spots and securely bonded to the ceramic substrate or article.

2. The method of claim 1 wherein the substrate is completely coated with the metal deposit and portions of said deposit are removed in a later step thus forming the conductors of a printed circuit pattern.

3. The method of claim 2 wherein the metal deposit is first provided with a masking layer corresponding the desired conductor pattern and the exposed metal is subsequently removed by etching.

4. The method of claim 1 wherein the surface of the ceramic substrate or article is selectively rendered receptive to metal deposition in the area corresponding a printed circuit conductor pattern to be formed.

5. The method of claim 1 wherein the entire surface is rendered receptive for metal deposition and subsequently provided with a masking layer corresponding the negative of a desired printed circuit conductor pattern.

6. The method of claims 1 to 5 wherein the substrate is provided with at least one hole having metallized walls.

EP 0 133 201 B1

7. The method of claims 1 to 6 wherein the substrate is transferred without rinsing from the pre-treatment solution to the first solution of a sequence for rendering its surface receptive to metal deposition.

8. The method of claims 1 to 7 wherein the alkali metal compound is selected from hydroxides, carbonates, nitrates, hydrogen sulfates and mixtures thereof.

9. The method of claim 8 wherein said mixture is an eutectic mixture.

10. The method of claim 8 or 9 wherein said melt further comprises one or more compounds which depress the melting point.

11. The method of claim 10 wherein said further compound(s) is (are) present in an amount of 20% by weight or more.

12. The method of claim 1 wherein the surface active compound is alkylphenoxypolyglycidol, a quaternary compound selected from quaternary ammonium chloride, polyethoxylated quaternary ammonium chloride, polypropoxylated quaternary ammonium chloride and complex quaternary surfactants, pyridinium compounds including cetyl pyridinium bromide, myristylcetyldimethylamine oxide, ethanolamine and poly(propoxy)poly(ethoxy)ethanolethylenediamine, alkylolamides and ethoxylated alkylolamides, lauric ethoxylated amide, creatine and tallow betaine surfactants.

13. The method of claim 1 wherein the metal deposit is formed by electroless or electroplating or a combination of both.

14. The method of claim 1 wherein the ceramic article or substrate, prior to step (b), is rinsed, neutralized and rinsed again.

**Patentansprüche:**

1. Verfahren zum teilweisen oder vollständigen Beschichten eines keramischen Gegenstandes oder Substrats mit einer auf dem genannten Gegenstand oder Substrat festhaftenden und direkt an diese gebundenen Metallschicht, gekennzeichnet durch die folgenden Verfahrensschritte:

(a) Behandeln der Substratoberfläche mit einer Schmelze aus einer oder mehreren Alkalimetall-Verbindung(en);

(b) Behandeln der genannten Oberfläche mit einer Lösung, die eine oberflächenaktive Verbindung enthält, ausgewählt aus äthoxylierten, nicht-ionischen Verbindungen sowie stickstoffhaltigen Verbindungen, die entweder eine quaternäre Ammoniumgruppe oder Aminoxydgruppen enthalten sowie solche aus der Gruppe der Alkanolamine, der Amide, Betaine, Aminosäuren und Guanidin sowie deren Derivate, und Mischungen der genannten, in einer Menge, die ausreicht, um eine gleichmäßige und sichere Adsorption von auf die Metallabscheidung katalytisch wirkenden Keimen in der genannten Oberfläche zu erzielen, wobei die genannte Lösung einen pH Wert von 2 aufweist und entweder in einem Vorbehandlungsschritt vor oder als Teil der Lösung oder Lösungen zur Katalysierung der genannten Oberfläche für die Metallabscheidung verwendet wird; und

(c) Tauchen der so vorbehandelten Oberfläche als Ganzes oder bestimmter Bezirke in eine Metallisierungsbadlösung zum Abscheiden der gewünschten Metallschicht auf der Oberfläche und Herstellen einer im wesentlichen vollkommen gleichmäßigen, von Fehlstellen freien und fest auf dem keramischen Gegenstand oder Substrat verankerten und direkt an diese gebundenen Schicht des gewünschten Metalls.

2. Verfahren nach Anspruch 1, dadurch gekennzeichnet, daß das Substrat zunächst vollständig mit der gewünschten Metallschicht bedeckt wird und in einem späteren Verfahrensschritt Teile der genannten Metallschicht entfernt und so ein Schaltungsmuster hergestellt wird.

3. Verfahren nach Anspruch 2, dadurch gekennzeichnet, daß die Metallschicht zunächst mit einer dem gewünschten Schaltungsmuster entsprechenden Abdeckmaske versehen wird und nachfolgend das freiliegende Metall durch Ätzen entfernt wird.

4. Verfahren nach Anspruch 1, dadurch gekennzeichnet, daß die Oberfläche des keramischen Gegenstandes oder Substrats nur in bestimmten, dem gewünschten Schaltungsmuster entsprechenden Bezirken für die Abscheidung aus Metallplattierungsbadlösungen katalysiert wird.

5. Verfahren nach Anspruch 1, dadurch gekennzeichnet, daß die gesamte Oberfläche für die Metallabscheidung katalysiert und nachfolgend eine Negativmaske des gewünschten Schaltungsmusters aufgebracht wird.

6. Verfahren nach den Ansprüchen 1 bis 5, dadurch gekennzeichnet, daß das Substrat mindestens ein Loch mit metallisierten Wandungen aufweist.

7. Verfahren nach den Ansprüchen 1 bis 6, dadurch gekennzeichnet, daß das Substrat ohne Zwischenschalten eines Spülschritts nach der Behandlung mit der oberflächenaktiven Verbindung in die erste von mehreren Lösungen zum Katalysieren der Oberfläche für die Metallabscheidung gebracht wird.

8. Verfahren nach den Ansprüchen 1 bis 7, dadurch gekennzeichnet, daß die Alkalimetall-Verbindung aus Hydroxiden, Carbonaten, Nitraten, Wasserstoffsulfaten und Mischungen derselben ausgewählt wird.

9. Verfahren nach Anspruch 8, dadurch gekennzeichnet, daß die genannte Mischung eutektisch ist.

10. Verfahren nach den Ansprüchen 8 oder 9, dadurch gekennzeichnet, daß die Mischung weiterhin einen oder mehrere Verbindungen zum Niedrighalten des Schmelzpunktes enthält.

11. Verfahren nach Anspruch 10, dadurch gekennzeichnet, daß die genannte(n) weitere(n) Verbindung(en) in einer Menge von 20 Gew.% oder mehr in der Mischung vorhanden sind.

EP 0 133 201 B1

12. Verfahren nach Anspruch 1, dadurch gekennzeichnet, daß die oberflächenaktive Verbindung Alkylphenoxypolyglycidol, eine quaternäre Verbindung ausgewählt aus quaternärem Ammoniumchlorod, polyäthoxyliertem quaternärem Ammoniumchlorid, polypropoxyliertem quaternärem Ammoniumchlorid und komplexen quaternären Benetzern, Pyridinverbindungen einschließlich Cetylpyridinbromid, Myristylcetyldimethylaminoxid, Äthanolamin und poly(propoxy)poly(äthoxy)äthanoläthalendiamin, Aklylolamiden und äthoxylierten Alkylolamiden, Laurinäthoxyliertem Amid, Creatin und Tallowbetain ist bzw. sind.

13. Verfahren nach Anspruch 1, dadurch gekennzeichnet, daß die Metallschicht entweder stromlos oder durch Elektroplattieren abgeschieden wird.

14. Verfahren nach Anspruch 1, dadurch gekennzeichnet, daß der keramische Gegenstand oder das Substrat vor dem Verfahrensschritt b) gespült, neutralisiert und erneut gespült wird.

**Revendications**

1. Procédé pour appliquer partiellement ou complètement un revêtement sur un article ou un substrat en céramique d'une couche métallique liée directement et solidement à l'article ou au substrat comprenant les étapes consistant à:

(a) traiter la surface du substrat avec une masse fondue comprenant un ou plusieurs composés de métaux alcalins; et

(b) exposer la surface à une solution comportant un agent tensio-actif choisi parmi les composés éthoxylés non-ioniques et les composés contenant de l'azote, choisis parmi des composés quaternaires, des oxydes d'amines, des alcanolamines, des amides, des bétaïnes, des aminoacides et la guanadine et leurs dérivés, et des mélanges des précédents, dans une quantité suffisante pour stimuler une adsorption uniforme et sûre des espèces rendant la surface réceptrice à un dépôt d'un métal, la solution ayant un pH de 2 et étant utilisée dans une étape de pré-traitement précédant, ou constituant une partie de la ou des solutions employées dans la séquence du procédé pour rendre la surface réceptrice à un dépôt d'un métal; et

(c) exposer la surface ainsi traitée ou des parties sélectionnées de celle-ci à une solution d'un bain de revêtement métallique pour déposer le métal désiré sur la surface, formant ainsi; un dépôt pratiquement complètement uniforme, exempt de défauts, ne comportant aucun points mis à nu et fixé solidement au substrat ou à l'article en céramique.

2. Procédé selon la revendication 1, dans lequel le substrat est complètement revêtu du dépôt métallique et des parties du dépôt sont enlevées dans une étape ultérieure, formant ainsi les conducteurs d'un motif à circuits imprimés.

3. Procédé selon la revendication 2, dans lequel le dépôt de métal est tout d'abord effectué avec une couche de masquage correspondant au motif désiré pour les conducteurs et le métal exposé est ensuite enlevé par gravure.

4. Procédé selon la revendication 1, dans lequel la surface du substrat ou de l'article en céramique est rendue sélectivement respectrice au dépôt métallique dans la zone correspondant à un motif de conducteurs de circuits imprimés devant être formé.

5. Procédé selon la revendication 1, dans lequel la totalité de la surface est rendue réceptrice au dépôt métallique et est ensuite munie d'une couche de masquage qui correspond au négatif du motif désiré pour les conducteurs des circuits imprimés.

6. Procédé selon les revendications 1 à 5, dans lequel le substrat comporte au moins un trou ayant des parois métallisées.

7. Procédé selon les revendications 1 à 6, dans lequel le substrat est transféré sans rinçage de la solution de pré-traitement à la première solution d'une séquence permettant de rendre sa surface réceptrice au dépôt métallique.

8. Procédé selon les revendications 1 à 7, dans lequel le composé de métal alcalin est choisi parmi les hydroxydes, carbonates, nitrates, sulfates acides et leurs mélanges.

9. Procédé selon la revendication 8, dans lequel le mélange est un mélange eutectique.

10. Procédé selon la revendication 8 ou la revendication 9, dans lequel la masse fondue comprend en outre un ou plusieurs composés qui abaissent le point de fusion.

11. Procédé selon la revendication 10, dans lequel le ou les autres composés sont présents suivant une quantité de 20 % en poids ou plus.

12. Procédé selon la revendication 1, dans lequel le composé tensio-actif est l'alkylphénoxypolyglycidol, un composé quaternaire choisi parmi le chlorure d'ammonium quaternaire, le chlorure d'ammonium quaternaire polyéthoxylé, le chlorure d'ammonium quaternaire polypropoxylé et des agents tensio-actifs quaternaires complexes, les composés de pyridinium comprenant le bromure de cétylpyridinium, l'oxyde de myristylcétyldiméthylamine, l'éthanolamine et le poly(propoxy)poly(éthoxy)-éthanoléthylènediamine, les alkylolamides et les alkylolamides éthoxylées, l'amide laurique éthoxylée, et les agents tensio-actifs en créatine et bétaïne de suif.

13. Procédé selon la revendication I, dans lequel le dépôt métallique est formé par un procédé autocatalytique ou un procédé de galvanolplastie ou par une combinaison des deux.

14. Procédé selon la revendication 1, dans lequel l'article ou le substrat en céramique, avant l'étape (b), est rincé, neutralisé et de nouveau rincé.

11